# EUROPÄISCHE PATENTSCHRIFT

(11) **EP 3 879 705 B1**
(45) Veröffentlichungstag und Bekanntmachung des Hinweises auf die Patenterteilung: **08.04.2026**
(21) Anmeldenummer: 21158205.1
(22) Anmeldetag: 19.02.2021
(51) Int. Cl.: H03K 17/96

(54) **SCHICHTANORDNUNG FÜR EIN BELEUCHTETES BEDIENELEMENT**
LAYER ARRANGEMENT FOR AN ILLUMINATED CONTROL ELEMENT
AGENCEMENT DE COUCHES POUR UN ÉLÉMENT DE COMMANDE ILLUMINÉ

(30) Priorität: 10.03.2020 DE 102020202993
(43) Veröffentlichungstag der Anmeldung: 15.09.2021
(73) Patentinhaber: BSH Hausgeräte GmbH, 81739 München (DE)
(72) Erfinder: Stefanic, Michal, 07211 Cecehov (SK); Zei, Carsten, 93161 Sinzing (DE)

(56) Entgegenhaltungen:
- EP-A2- 1 970 479
- EP-A2- 3 280 053
- EP-B1- 1 970 479
- US-A1- 2010 259 497
- US-A1- 2016 301 411

## Beschreibung

Die Erfindung betrifft eine Schichtanordnung für ein beleuchtetes Bedienelement, insbesondere zur Verwendung in einem Hausgerät.

Hausgeräte, insbesondere Haushaltsgeräte wie z.B. Waschmaschinen oder Spülmaschinen, umfassen typischerweise einzelne mechanische Tasten oder Druckknöpfe, mit denen Funktionen des Hausgeräts (z.B. Optionen von Wasch- oder Spülprogrammen) ausgewählt werden können. Auf den Tasten bzw. Druckknöpfen ist typischerweise ein beleuchtetes Symbol oder ein Schriftzug angebracht, mit denen jeweils die ein oder mehreren Funktionen angezeigt werden, die durch die Tasten bzw. Druckknöpfe ausgewählt werden können.

Bei der Verwendung von mehreren beleuchteten Bedienelementen kann es zu gegenseitigen Beeinflussungen zwischen den beleuchteten Bereichen der unterschiedlichen Bedienelemente kommen. Des Weiteren kann es zu unscharfen Begrenzungen der beleuchteten Anzeige der einzelnen Bedienelemente kommen. EP 3 280 053 A2 beschreibt ein Bedienmodul für ein Haushaltsgerät. US 2010 / 0 259 497 A1 beschreibt einen Berührungssensor, der eine Elektrode als Symbol-Maske aufweist.

Das vorliegende Dokument befasst sich mit der technischen Aufgabe, eine Schichtanordnung für ein beleuchtetes Bedienelement bereitzustellen, die eine klare Abgrenzung eines beleuchteten Bereichs des Bedienelements ermöglicht.

Die Aufgabe wird durch den Gegenstand des unabhängigen Patentanspruchs gelöst. Vorteilhafte Ausführungsformen sind insbesondere in den abhängigen Patentansprüchen definiert, in nachfolgender Beschreibung beschrieben oder in der beigefügten Zeichnung dargestellt.

Gemäß einem Aspekt der Erfindung wird eine Schichtanordnung für zumindest ein Bedienelement beschrieben. Die Schichtanordnung kann eine Mehrzahl von Schichten umfassen. Dabei kann die Schichtanordnung ausgebildet sein, einen Annäherungs-, Berührungs- und/oder Betätigungssensor für zumindest ein Bedienelement und eine Anzeige für das zumindest eine Bedienelement bereitzustellen bzw. zu bilden.

Die Schichtanordnung umfasst ein Leuchtelement (z.B. mit ein oder mehreren lichtemittierenden Dioden, LEDs), das ausgebildet ist, eine Lichtkammer der Schichtanordnung zu beleuchten. Die Lichtkammer kann dabei durch ein oder mehrere Separatoren und/oder Reflektoren gebildet und/oder begrenzt werden, die die Lichtkammer in einer parallel zu den ein oder mehreren Schichten der Schichtanordnung verlaufenden Richtung lichtblockierend begrenzen. Mit anderen Worten, durch die ein oder mehrere Separatoren und/oder Reflektoren kann eine seitliche Begrenzung der (zumindest einen) Lichtkammer der Schichtanordnung, die senkrecht zu den ein oder mehreren Schichten der Schichtanordnung verläuft, gebildet werden. So kann das Licht eines Leuchtelements in zuverlässiger Weise innerhalb einer einzigen Lichtkammer gehalten werden. Die ein oder mehreren Separatoren und/oder Reflektoren der Schichtanordnung können durch eine Separator- und/oder Reflektorschicht gebildet werden.

Die Schichtanordnung umfasst eine die Lichtkammer bedeckende lichtblockierende Schicht mit (zumindest) einer Aussparung. Die lichtblockierende Schicht ist dabei im eingebauten Zustand der Schichtanordnung zwischen der Lichtkammer und der Bedienoberfläche eines Bedienelements angeordnet. Durch die lichtblockierende Schicht kann bewirkt werden, dass Licht aus der Lichtkammer nur durch die Aussparung aus der Lichtkammer an die Bedienoberfläche eines Bedienelements gelangen kann. Mit anderen Worten, die lichtblockierende Schicht kann ausgebildet sein, den Lichtaustritt aus der Lichtkammer auf den Bereich der Aussparung zu begrenzen.

Die lichtblockierende Schicht kann eine intransparente Kunststoff-, insbesondere Polyethylenterephthalat, kurz PET, Schicht umfassen. Insbesondere kann die lichtblockierende Schicht eine intransparente Kunststoff- (z.B. PET) Schicht sein. Beispielsweise kann die lichtblockierende Schicht schwarz sein. So kann in besonders effizienter und zuverlässiger Weise der Austritt von Licht aus der Lichtkammer auf die zumindest eine Aussparung (z.B. auf einen Durchbruch bzw. auf ein Loch) der lichtblockierenden Schicht begrenzt werden. Die lichtblockierende Schicht kann z.B. auf eine andere Schicht der Schichtanordnung aufgedruckt oder aufgeklebt sein.

Die Aussparung der lichtblockierenden Schicht ist bevorzugt derart angeordnet, dass die Aussparung der lichtblockierenden Schicht vollständig von dem Leuchtelement ausgeleuchtet wird. Mit anderen Worten, die Aussparung kann direkt über der Lichtkammer angeordnet sein. So kann bewirkt werden, dass durch den Rand der Aussparung eine klar definierte Begrenzung des ausgeleuchteten Bereichs der Anzeige eines Bedienelements bereitgestellt werden kann. Ggf. kann durch den Rand der Aussparung der Rand des ausgeleuchteten Bereichs der Anzeige eines Bedienelements definiert sein.

Die Schichtanordnung umfasst ferner eine die Aussparung der lichtblockierenden Schicht bedeckende Sensorschicht. Die Sensorschicht kann dabei elektrisch leitend sein. Die Sensorschicht kann z.B. ein Metall, insbesondere Kupfer, Gold und/oder Silber, umfassen bzw. aus einem Metall bestehen. Die Sensorschicht kann z.B. aufgeklebt oder aufgedruckt worden sein. Beispielsweise kann eine Kupferschicht auf eine andere Schicht der Schichtanordnung aufgeklebt worden sein. In einem weiteren Beispiel kann eine Silberschicht auf eine andere Schicht der Schichtanordnung aufgedruckt worden. Die Sensorschicht kann Teil eines kapazitiven und/oder resistiven (Berührungs- und/oder Annäherungs-) Sensors sein.

Die Sensorschicht kann derart ausgebildet sein, dass die Sensorschicht an dem Rand der Aussparung mit der lichtblockierenden Schicht überlappt, so dass am Rand der Aussparung ein überlappender Bereich gebildet wird, in dem sich die lichtblockierende Schicht und die Sensorschicht überlappen.

Dabei können sich die Sensorschicht und die lichtblockierende Schicht in dem überlappenden Bereich berühren. Mit anderen Worten, die Sensorschicht und die lichtblockierende Schicht können in dem überlappenden Bereich direkt aufeinander liegen. Des Weiteren können die Sensorschicht und die lichtblockierende Schicht in dem überlappenden Bereich miteinander verbunden, insbesondere miteinander verklebt, sein.

Durch das Überlappen der Sensorschicht und der lichtblockierenden Schicht kann in zuverlässiger Weise bewirkt werden, dass an dem Rand der Aussparung der lichtblockierenden Schicht kein Licht an der Sensorschicht vorbei aus der Lichtkammer gelangen kann, was zu einer diffusen Beleuchtung der Anzeige eines Bedienelements führen könnte.

Die Sensorschicht ist zumindest in dem überlappenden Bereich lichtblockierend.

So kann der Austritt von Licht aus der Lichtkammer im Randbereich der Aussparung in zuverlässiger Weise unterbunden werden.

Der überlappende Bereich weist eine Überlappungsbreite auf, die derart groß ist, dass substantiell kein Licht aus der Lichtkammer durch den überlappenden Bereich sichtbar ist. Die Überlappungsbreite kann z.B. 1mm oder mehr oder 2mm oder mehr sein. So kann eine besonders klar begrenzte Ausleuchtung der Anzeige eines Bedienelements bewirkt werden.

Alternativ oder ergänzend kann der überlappende Bereich derart ausgebildet sein, dass der überlappende Bereich einen geschlossenen und/oder vollständig umlaufenden Rahmen um die Aussparung der lichtblockierenden Schicht bildet. So kann eine besonders klar begrenzte Ausleuchtung der Anzeige eines Bedienelements bewirkt werden.

Die Aussparung weist bevorzugt eine kleinere Fläche auf als die zu bedeckende Öffnung der Lichtkammer. Mit anderen Worten, die Aussparung kann derart ausgebildet sein, dass die Lichtkammer zumindest teilweise durch die lichtblockierende Schicht bedeckt wird. Dabei liegt der Rand der Aussparung bevorzugt vollständig innerhalb der zu bedeckenden Öffnung der Lichtkammer, so dass die lichtblockierende Schicht über den gesamten Rand der zu bedeckenden Öffnung der Lichtkammer hinausragt. So kann eine besonders klare Abgrenzung der Beleuchtung der Anzeige eines Bedienelements bewirkt werden.

Die Sensorschicht kann ein oder mehrere lichtblockierende Teilbereiche und ein oder mehrere lichtdurchlässige Teilbereiche aufweisen, die zusammen eine Maske für (zumindest) ein von dem Leuchtelement zu beleuchtendes Symbol bilden. Insbesondere kann die Sensorschicht lichtblockierend sein, und ein oder mehrere Aussparungen (d.h. lichtdurchlässige Teilbereiche) aufweisen, durch die Licht hindurchtreten kann. So kann in besonders effizienter Weise ein Symbol für die Anzeige eines Bedienelements bereitgestellt werden. Insbesondere kann es durch die Verwendung der Sensorschicht als Maske für ein oder mehrere Symbole ermöglicht werden, auf eine separate bedruckte Schicht zu verzichten.

Es kann somit eine (zusammenhängende) Schichtanordnung bereitgestellt werden, bei der das Licht eines Leuchtelements durch eine lichtblockierende (Blockier-) Schicht und eine (lichtblockierende) Sensorschicht, die sich in einem überlappenden Bereich überlappen, derart blockiert wird, dass das Licht nur durch ein oder mehrere lichtdurchlässige Teilbereiche der Sensorschicht aus der Lichtkammer austreten kann. So kann in effizienter Weise eine klar begrenzte Beleuchtung der Anzeige eines Bedienelements ermöglicht werden.

Die Sensorschicht kann auf einer von dem Leuchtelement abgewandten Seite der lichtblockierenden Schicht angeordnet sein. Alternativ oder ergänzend kann die Sensorschicht auf einer dem Leuchtelement zugewandten Seite der lichtblockierenden Schicht angeordnet sein. So kann in zuverlässiger Weise eine Blockade von Licht in dem überlappenden Bereich der lichtblockierenden Schicht und der Sensorschicht bewirkt werden.

Die Schichtanordnung kann eine optische Diffusorschicht umfassen, die zwischen dem Leuchtelement bzw. der Lichtkammer und der lichtblockierenden Schicht, insbesondere der Aussparung der lichtblockierenden Schicht, angeordnet ist. Durch die Bereitstellung einer Diffusorschicht kann eine homogene Ausleuchtung einer Anzeige eines Bedienelements bewirkt werden.

Die Schichtanordnung kann eine lichtdurchlässige Trägerschicht (z.B. eine transparente PET Schicht) umfassen, die an der von dem Leuchtelement abgewandten Seite der lichtblockierenden Schicht und/oder der Sensorschicht angeordnet ist. Die Trägerschicht kann somit der Berühroberfläche eines Bedienelements zugewandt sein. Durch die Verwendung einer Trägerschicht kann die Stabilität der Schichtanordnung weiter erhöht werden.

Die Schichtanordnung kann eine Mehrzahl von Lichtkammern für eine entsprechende Mehrzahl von Bedienelementen umfassen. Des Weiteren kann die lichtblockierende Schicht eine Mehrzahl von Aussparungen für die entsprechende Mehrzahl von Lichtkammern umfassen. Es können somit mit einer einzigen Schichtanordnung mehrere Bedienelemente bereitgestellt werden, die separat beleuchtet werden können. Dabei kann durch die in diesem Dokument beschriebenen Maßnahmen zuverlässig vermieden werden, dass das Licht eines Bedienelements die Beleuchtung eines anderen Bedienelements stört.

Gemäß einem weiteren Aspekt wird ein Bedienelement beschrieben, das einen Annäherungs-, Berührungs- und/oder Betätigungssensor zur Erkennung einer Annäherung, Berührung und/oder Betätigung des Bedienelements durch einen Nutzer, sowie eine beleuchtete Anzeige (z.B. mit einem beleuchteten Symbol) umfasst. Des Weiteren umfasst das Bedienelement eine in diesem Dokument beschriebene Schichtanordnung. Dabei können der Annäherungs-, Berührungs- und/oder Betätigungssensor und die beleuchtete Anzeige zumindest teilweise oder vollständig durch die Schichtanordnung gebildet werden.

Gemäß einem weiteren Aspekt wird ein Hausgerät, insbesondere ein Haushaltsgerät, etwa ein Herd, ein Ofen, eine Waschmaschine, eine Spülmaschine, ein Küchengerät, ein Trockner, ein Kochfeld, ein Kühlschrank, etc., beschrieben, das zumindest eines der in diesem Dokument beschriebenen Bedienelemente umfasst.

Es ist zu beachten, dass jegliche Aspekte der in diesem Dokument beschriebenen Schichtanordnung in vielfältiger Weise miteinander kombiniert werden können. Insbesondere können die Merkmale der Patentansprüche in vielfältiger Weise miteinander kombiniert werden.

Im Weiteren wird die Erfindung anhand von in der beigefügten Zeichnung dargestellten Ausführungsbeispielen näher beschrieben. Dabei zeigen
Figur 1a ein Blockdiagramm eines beispielhaften Hausgeräts;
Figur 1b ein beispielhaftes Bedienelement;
Figur 2a eine beispielhafte Schichtanordnung in einer Draufsicht; und
Figur 2b eine beispielhafte Schichtanordnung in einer Schnitt- bzw. Seitenansicht.

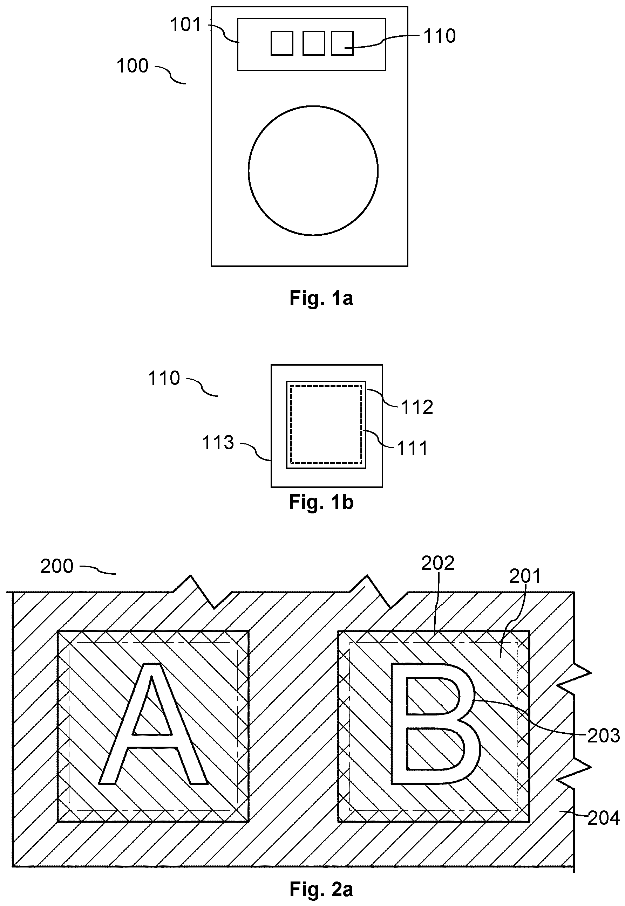

Wie eingangs dargelegt, befasst sich das vorliegende Dokument mit der Bereitstellung einer Schichtanordnung für ein Bedienelement, die eine klare Abgrenzung der Beleuchtung des Bedienelements, insbesondere eines bestimmten beleuchteten Teilbereichs des Bedienelements, ermöglicht. In diesem Zusammenhang zeigt Fig. 1a ein beispielhaftes Hausgerät 100, insbesondere eine Waschmaschine bzw. einen Trockner, das eine Bedienblende 101 mit ein oder mehrere Bedienelementen 110 umfasst. Beispielhafte Bedienelemente 110 sind Tasten, Druckknöpfe, Schieberegler und/oder Drehknöpfe.

Ein Bedienelement 110 umfasst, wie in Fig. 1b dargestellt, eine Bedienfläche bzw. Bedienoberfläche 113, die von einem Nutzer berührt (insbesondere gedrückt) werden kann, um das Bedienelement 110 zu betätigen. Des Weiteren umfasst ein Bedienelement 110 typischerweise einen Annäherungs-, Berührungs- und/oder Betätigungssensor 112, der ausgebildet ist, eine Annäherung, eine Berührung und/oder eine Betätigung des Bedienelements 110 durch einen Nutzer, insbesondere durch die Hand eines Nutzers, zu detektieren. Ein beispielhafter Annäherungs-, Berührungs- und/oder Betätigungssensor 112 ist ein kapazitiver Sensor. Der Annäherungs-, Berührungs- und/oder Betätigungssensor 112 kann an und/oder hinter der Bedienfläche 113 des Bedienelements 110 angeordnet sein.

Des Weiteren umfasst ein Bedienelement 110 typischerweise eine Anzeige 111, die die Funktion des Hausgeräts 100 anzeigt, welche durch Betätigen des Bedienelements 110 ausgelöst werden kann. Die Anzeige 111 kann dabei beleuchtet sein, um die Lesbarkeit der Anzeige 111 zu verbessern. Die Anzeige 111 kann an der Bedienfläche 113 des Bedienelements 110 angeordnet sein. Die Anzeige 111 kann ein oder mehrere beleuchtete Symbole umfassen.

Ein Bedienelement 110, insbesondere der Annäherungs-, Berührungs- und/oder Betätigungssensor 112 und die Anzeige 111 eines Bedienelements 110, können in effizienter Weise mittels einer Schichtanordnung (auch als Schichtverbund bezeichnet) aus mehreren Schichten bereitgestellt werden. Dabei können die Schichten unterschiedliche Funktionen, z.B. eine Sensorfunktion oder eine Beleuchtungsfunktion, aufweisen. Die unterschiedlichen Schichten können zusammengefügt, insbesondere miteinander verklebt, sein, um die Schichtanordnung bereitzustellen.

Mittels einer Schichtanordnung können in besonders effizienter Weise mehrere Bedienelemente 110 bereitgestellt werden. Dabei kann es jedoch zu einer gegenseitigen Beeinflussung der Beleuchtung von unterschiedlichen Bedienelementen 110 kommen.

Des Weiteren kann es zum Austritt von Licht an den Begrenzungen der einzelnen Bedienelemente 110 kommen.

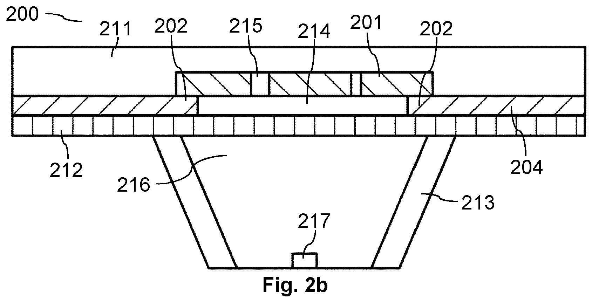

In den Figuren 2a und 2b ist eine Schichtanordnung 200 dargestellt, die eine klare Ab- und Begrenzung der Beleuchtung von einzelnen Bedienelementen 110 ermöglicht. Dabei zeigt Fig. 2a die Schichtanordnung 200 in einer Draufsicht (d.h. von einer Seite die im eingebauten Zustand der Bedienfläche 113 der ein oder mehreren Bedienelemente 110 zugewandt ist). Fig. 2b zeigt die Schichtanordnung 200 in einer Seiten- bzw. Schnittansicht, entlang einer Schnittfläche, die im eingebauten Zustand der Schichtanordnung 200 senkrecht zu der Bedienfläche 113 eines Bedienelements 110 verläuft.

Die Schichtanordnung 200 umfasst typischerweise eine (transparente) Trägerschicht 211 (z.B. eine Polyethylenterephthalat, kurz PET, Schicht), die im eingebauten Zustand der Bedienfläche 113 der ein oder mehreren Bedienelemente 110 zugewandt ist. Die Trägerschicht 211 hat typischerweise die Aufgabe, die Schichtanordnung 200 zu stabilisieren und/oder die ein oder mehreren anderen Schichten der Schichtanordnung 200 zu tragen.

Des Weiteren umfasst die Schichtanordnung 200 eine lichtblockierende und/oder intransparente Blockierschicht 204, die ausgebildet ist, Licht, insbesondere Licht von ein oder mehreren Leuchtelementen 217 der Schichtanordnung 200, zu blockieren. Die Blockierschicht 204 ist zu diesem Zweck zwischen der Trägerschicht 211 und den ein oder mehreren Leuchtelementen 217 (z.B. lichtemittierenden Dioden, LEDs) zur Beleuchtung der Anzeigen 111 von ein oder mehreren Bedienelementen 110 angeordnet. Die Blockierschicht 204 kann eine lichtblockierende (z.B. eine schwarze) PET-Schicht umfassen, insbesondere sein.

Die Blockierschicht 204 weist zumindest eine Aussparung 214, z.B. einen Durchbruch, ein Loch, einen ausgeschnittenen bzw. ausgestanzten Bereich, etc., auf. Eine Aussparung 214 ermöglicht es, dass Licht von einem dahinter liegenden Leuchtelement 217 durch die Aussparung 214 und durch die (optionale) Trägerschicht 211 treten kann. Durch den Rand einer Aussparung 214 in der Blockierschicht 204 wird dabei eine klare Begrenzung des beleuchteten Bereichs der Trägerschicht 211 definiert. Der Rand kann z.B. eine rechteckige oder kreisförmige Begrenzung des beleuchteten Bereichs der Trägerschicht 211 definierten.

Die Schichtanordnung 200 umfasst ferner eine (intransparente und/oder lichtblockierende) Sensorschicht 201. Die Sensorschicht 201 kann z.B. elektrisch leitend sein, z.B. um einen kapazitiven Sensor bereitzustellen. Insbesondere kann durch die Sensorschicht 201 der Annäherungs-, Berührungs- und/oder Betätigungssensor 112 eines Bedienelements 110 gebildet werden. Die Sensorschicht 201 ist derart in der Schichtanordnung 200 angeordnet, dass die Sensorschicht 201 zumindest bzw. genau eine Aussparung 214 der Blockierschicht 204 bedeckt.

Das Bedecken der Aussparung 214 kann derart erfolgen, dass an dem Rand der Aussparung 214 kein Spalt vorliegt, durch den Licht des Leuchtelements 217 scheinen kann. Die Sensorschicht 201 kann somit eine Aussparung 214 der Blockierschicht 204 derart bedecken, dass das Licht einer hinter der Blockierschicht 204 liegenden Leuchtquelle 217 zumindest an dem Rand der Aussparung 214 vollständig abgeschirmt wird. Zu diesem Zweck können die Sensorschicht 201 und die Blockierschicht 204 an dem Rand der Aussparung 214 überlappend angeordnet sein. Insbesondere können die Sensorschicht 201 und die Blockierschicht 204 an dem Rand der Aussparung 214 einen überlappenden Bereich 202 bilden, in dem die Blockierschicht 204 und die Sensorschicht 201 (direkt) übereinander angeordnet sind. Der überlappende Bereich 202 kann dabei entlang des Randes der Aussparung 214 verlaufen und einen (vollständig umlaufenden) Rahmen um die Aussparung 214 bilden.

In dem überlappenden Bereich 202 können die Blockierschicht 204 und die Sensorschicht 201 direkt miteinander verbunden, insbesondere verklebt, sein. Die Breite des überlappenden Bereichs 202 (entlang der Ausbreitungsrichtung der Schichten 201, 204) ist dabei bevorzugt ausreichend groß, um ein Austreten von Licht des Leuchtelements 217 an dem überlappenden Bereich 202 zuverlässig zu vermeiden. Die Breite kann z.B. 1mm oder mehr oder 2mm oder mehr sein.

Die Sensorschicht 201 kann ein oder mehrere transparente und/oder lichtdurchlässige Teilbereiche 215 umfassen, wobei die ein oder mehreren transparenten und/oder lichtdurchlässigen Teilbereiche 215 von dem überlappenden Bereich 202 umrandet werden und im Bereich der Aussparung 214 der Blockierschicht 204 angeordnet sind, so dass Licht des Leuchtelements 217 durch die ein oder mehreren transparenten und/oder lichtdurchlässigen Teilbereiche 215 bis zu der Trägerschicht 211 gelangen kann.

Die ein oder mehreren transparenten und/oder lichtdurchlässigen Teilbereiche 215 können somit zur Beleuchtung der Anzeige 111 eines Bedienelements 110 verwendet werden. Dabei kann durch die ein oder mehreren transparenten und/oder lichtdurchlässigen Teilbereiche 215 eine Maske für ein oder mehrere darzustellende Symbole 203 gebildet werden. Die ein oder mehreren Symbole 203, die auf einem beleuchteten Bedienelement 110 dargestellt werden sollen, können somit durch ein oder mehreren transparenten und/oder lichtdurchlässigen Teilbereiche 215 in der Sensorschicht 201 der Schichtanordnung 200 gebildet werden. So kann auf die Verwendung einer separaten bedruckten Schicht verzichtet werden.

Die Sensorschicht 201 kann, wie in Fig. 2b dargestellt, zwischen der Trägerschicht 211 und der Blockierschicht 204 angeordnet sein (so dass die Sensorschicht 201 die der Trägerschicht 211 zugewandte Seite der Blockierschicht 204 berührt). Alternativ oder ergänzend kann die Sensorschicht 201 zwischen der Blockierschicht 204 und dem Leuchtelement 217 angeordnet sein (so dass die Sensorschicht 201 die von der Trägerschicht 211 abgewandte Seite der Blockierschicht 204 berührt). So kann eine besonders zuverlässige Blockade des Lichtes an dem Rand der Aussparung 214 bewirkt werden.

Das Leuchtelement 217 kann in einer Lichtkammer 216 angeordnet sein, die in Bezug auf die Trägerschicht 211 und/oder in Bezug auf die Bedienfläche 113 eines Bedienelements 110 hinter der Blockierschicht 204 angeordnet ist. Die Lichtkammer 216 kann zumindest seitlich durch ein oder mehrere Lichtreflektoren 213 begrenzt sein. Die ein oder mehreren Lichtreflektoren 213 können dabei einen Becher bzw. einen Behälter bilden, in dem zumindest ein Leuchtelement 217 (z.B. eine LED) angeordnet ist. Die durch die ein oder mehreren Lichtreflektoren 213 gebildete (becherförmige) Lichtkammer 216 kann durch die Blockierschicht 204 mit der zumindest einen Aussparung 214 bedeckt sein. Die zumindest eine Aussparung 214 kann dabei direkt über der Lichtkammer 216 angeordnet sein, so dass die gesamte Aussparung 214 mit Licht aus der Lichtkammer 216 angestrahlt wird.

Zwischen der Lichtkammer 216 und der Blockierschicht 204 bzw. der Aussparung 214 der Blockierschicht 204 kann eine Diffusorschicht 212 angeordnet sein, die ausgebildet ist, das Licht des Leuchtelements 217 zu streuen. Durch die Bereitstellung einer Diffusorschicht 212 kann eine gleichmäßige Beleuchtung der Aussparung 214 der Blockierschicht 204 (und damit der Anzeige 111 eines Bedienelements 110) bewirkt werden.

Durch die in diesem Dokument beschriebenen Maßnahmen kann in besonders effizienter Weise (insbesondere ohne Verwendung einer zusätzlichen bedruckten Schicht zur Darstellung eines Symbols 203) eine klar definierte Ausleuchtung der ein oder mehreren Symbole 203 einer Anzeige 111 eines Bedienelements 110 ermöglicht werden. Dabei kann das Austreten von Licht an den Rändern der Anzeige 111 und/oder an den Rändern des Sensors 112 eines Bedienelements 110 zuverlässig vermieden werden. Des Weiteren kann der Übertritt von Licht auf benachbarte Bedienelemente 110 zuverlässig vermieden werden. Ferner wird es ermöglicht, in effizienter Weise durch eine einzige Schichtanordnung 200 sowohl eine Sensorfunktion als auch eine (beleuchtete) Anzeigefunktion bereitzustellen.

## Patentansprüche

1. Schichtanordnung (200) für ein Bedienelement (110); wobei die Schichtanordnung (200) umfasst,
- ein Leuchtelement (217), das ausgebildet ist, eine Lichtkammer (216) der Schichtanordnung (200) zu beleuchten;
- eine die Lichtkammer (216) bedeckende lichtblockierende Schicht (204) mit einer Aussparung (214); und
eine die Aussparung (214) der lichtblockierenden Schicht (204) bedeckende Sensorschicht (201); wobei die Sensorschicht (201) an einem Rand der Aussparung (214) mit der lichtblockierenden Schicht (204) überlappt, so dass am Rand der Aussparung (214) ein überlappender Bereich (202) gebildet wird, in dem sich die lichtblockierende Schicht (204) und die Sensorschicht überlappen; wobei die Sensorschicht (201) zumindest in dem überlappenden Bereich (202) lichtblockierend ist; wobei die Sensorschicht (201) ein oder mehrere lichtblockierende Teilbereiche und ein oder mehrere lichtdurchlässige Teilbereiche (215) aufweist, die zusammen eine Maske für ein von dem Leuchtelement (217) zu beleuchtendes Symbol (203) bilden; wobei die Sensorschicht (201) in dem überlappenden Bereich (202) lichtblockierend ist; wobei sich die Sensorschicht (201) und die lichtblockierende Schicht (204) in dem überlappenden Bereich (202) berühren und in dem überlappenden Bereich (202) direkt miteinander verbunden sind, wobei der überlappende Bereich (202) eine Überlappungsbreite aufweist, die derart groß ist, dass substantiell kein Licht aus der Lichtkammer (216) durch den überlappenden Bereich (202) sichtbar ist, wobei
- die Sensorschicht (201) und die lichtblockierende Schicht (204) in dem überlappenden Bereich (202) direkt aufeinander liegen; und
- die Sensorschicht (201) und die lichtblockierende Schicht (204) in dem überlappenden Bereich (202) miteinander verklebt sind.

2. Schichtanordnung (200) gemäß Anspruch 1, wobei die Sensorschicht (201) auf einer von dem Leuchtelement (217) abgewandten Seite der lichtblockierenden Schicht (204) angeordnet ist.

3. Schichtanordnung (200) gemäß einem der vorhergehenden Ansprüche, wobei die Sensorschicht (201) auf einer dem Leuchtelement (217) zugewandten Seite der lichtblockierenden Schicht (204) angeordnet ist.

4. Schichtanordnung (200) gemäß einem der vorhergehenden Ansprüche, wobei
- der überlappende Bereich (202) derart ausgebildet ist, dass der überlappende Bereich (202) einen geschlossenen und/oder vollständig umlaufenden Rahmen um die Aussparung (214) der lichtblockierenden Schicht (204) bildet; und/oder
- der überlappende Bereich (202) eine Überlappungsbreite aufweist, die derart groß ist, dass substantiell kein Licht aus der Lichtkammer (216) durch den überlappenden Bereich (202) sichtbar ist.

5. Schichtanordnung (200) gemäß einem der vorhergehenden Ansprüche, wobei die Schichtanordnung (200) einen Separator und/oder Reflektor (213) umfasst, der die Lichtkammer (216) in einer parallel zu der blockierenden Schicht (204) verlaufenden Richtung lichtblockierend begrenzt.

6. Schichtanordnung (200) gemäß einem der vorhergehenden Ansprüche, wobei die Schichtanordnung (200) eine optische Diffusorschicht (212) umfasst, die zwischen dem Leuchtelement (217) und der lichtblockierenden Schicht (204), insbesondere der Aussparung (214) der lichtblockierenden Schicht (204), angeordnet ist.

7. Schichtanordnung (200) gemäß einem der vorhergehenden Ansprüche, wobei die Schichtanordnung (200) eine lichtdurchlässige Trägerschicht (211) umfasst, die an einer von dem Leuchtelement (217) abgewandten Seite der lichtblockierenden Schicht (204) angeordnet ist.

8. Schichtanordnung (200) gemäß einem der vorhergehenden Ansprüche, wobei die lichtblockierende Schicht (204) eine intransparente Kunststoff-, insbesondere Polyethylenterephthalat, kurz PET, Schicht umfasst, insbesondere ist.

9. Schichtanordnung (200) gemäß einem der vorhergehenden Ansprüche, wobei die Sensorschicht (201) elektrisch leitend ist.

10. Schichtanordnung (200) gemäß einem der vorhergehenden Ansprüche, wobei die Aussparung (214) der lichtblockierenden Schicht (204) derart angeordnet ist, dass die Aussparung (214) der lichtblockierenden Schicht (204) vollständig von dem Leuchtelement (217) ausgeleuchtet wird.

11. Schichtanordnung (200) gemäß einem der vorhergehenden Ansprüche, wobei
- die Schichtanordnung (200) eine Mehrzahl von Lichtkammern (216) für eine entsprechende Mehrzahl von Bedienelementen (110) umfasst; und
- die lichtblockierende Schicht (204) eine Mehrzahl von Aussparungen (214) für die entsprechende Mehrzahl von Lichtkammern (216) umfasst.

12. Bedienelement (110), das umfasst
- einen Annäherungs-, Berührungs- und/oder Betätigungssensor (112) zur Erkennung einer Annäherung, Berührung und/oder Betätigung des Bedienelements (110) durch einen Nutzer;
- eine beleuchtete Anzeige (111); und
- eine Schichtanordnung (200) gemäß einem der vorhergehenden Ansprüche; wobei der Annäherungs-, Berührungs- und/oder Betätigungssensor (112) und die beleuchtete Anzeige (111) zumindest teilweise oder vollständig durch die Schichtanordnung (200) gebildet werden.

13. Hausgerät (100), das zumindest ein Bedienelement (110) gemäß Anspruch 12 umfasst.

## Claims

1. Layer arrangement (200) for an operating element (110); wherein the layer arrangement (200) comprises
- an illumination element (217), which is embodied to illuminate a lighting chamber (216) of the layer arrangement (200);
- a light-blocking layer (204) which covers the lighting chamber (216), with a cutout (214); and
a sensor layer (201) which covers the cutout (214) of the light-blocking layer (204); wherein the sensor layer (201) overlaps with the light-blocking layer (204) at an edge of the cutout (214), so that, formed at the edge of the cutout (214), there is an overlapping region (202), in which the light-blocking layer (204) and the sensor layer overlap; wherein the sensor layer (201) is light-blocking at least in the overlapping region (202); wherein the sensor layer (201) has one or more light-blocking subregions and one or more subregions (215) which are permeable to light, which together form a mask for a symbol (203) to be illuminated by the illumination element (217); wherein the sensor layer (201) is light-blocking in the overlapping region (202); wherein the sensor layer (201) and the light-blocking layer (204) are in contact in the overlapping region (202) and are connected to one another in the overlapping region (202) directly, wherein the overlapping region (202) has an overlapping width, which is sized such that substantially no light from the lighting chamber (216) can be seen through the overlapping region (202), wherein
- the sensor layer (201) and the light-blocking layer (204) rest directly against one another in the overlapping region (202); and
- the sensor layer (201) and the light-blocking layer (204) are adhesively bonded to one another in the overlapping region (202).

2. Layer arrangement (200) according to claim 1, wherein the sensor layer (201) is arranged on a side of the light-blocking layer (204) that faces away from the illumination element (217).

3. Layer arrangement (200) according to one of the preceding claims, wherein the sensor layer (201) is arranged on a side of the light-blocking layer (204) that faces towards the illumination element (217).

4. Layer arrangement (200) according to one of the preceding claims, wherein
- the overlapping region (202) is embodied such that the overlapping region (202) forms a closed and/or fully circumferential frame around the cutout (214) of the light-blocking layer (204); and/or
- the overlapping region (202) has an overlapping width, which is sized such that substantially no light from the lighting chamber (216) can be seen through the overlapping region (202).

5. Layer arrangement (200) according to one of the preceding claims, wherein the layer arrangement (200) comprises a separator and/or reflector (213), which delimits the lighting chamber (216) in a light-blocking manner in a direction running in parallel with the blocking layer (204).

6. Layer arrangement (200) according to one of the preceding claims, wherein the layer arrangement (200) comprises an optical diffusor layer (212) which is arranged between the illumination element (217) and the light-blocking layer (204), in particular the cutout (214) of the light-blocking layer (204).

7. Layer arrangement (200) according to one of the preceding claims, wherein the layer arrangement (200) comprises a carrier layer (211) which is permeable to light and which is arranged on a side of the light-blocking layer (204) that faces away from the illumination element (217).

8. Layer arrangement (200) according to one of the preceding claims, wherein the light-blocking layer (204) comprises, in particular is, a non-transparent plastic layer, in particular polyethylene terephthalate, PET for short.

9. Layer arrangement (200) according to one of the preceding claims, wherein the sensor layer (201) is electrically conductive.

10. Layer arrangement (200) according to one of the preceding claims, wherein the cutout (214) of the light-blocking layer (204) is arranged such that the cutout (214) of the light-blocking layer (204) is fully illuminated by the illumination element (217).

11. Layer arrangement (200) according to one of the preceding claims, wherein
- the layer arrangement (200) comprises a plurality of lighting chambers (216) for a corresponding plurality of operating elements (110); and
- the light-blocking layer (204) comprises a plurality of cutouts (214) for the corresponding plurality of lighting chambers (216).

12. Operating element (110), which comprises
- a proximity, contact and/or actuation sensor (112) for identifying proximity, contact and/or actuation of the operating element (110) by a user;
- an illuminated display (111); and
- a layer arrangement (200) according to one of the preceding claims; wherein the proximity, contact and/or actuation sensor (112) and the illuminated display (111) are formed at least partially or fully by the layer arrangement (200).

13. Household appliance (100), which comprises at least one operating element (110) according to claim 12.

## Revendications

1. Agencement de couches (200) pour un élément de commande (110) ; dans lequel l'agencement de couches (200) comprend,
- un élément lumineux (217) formé pour éclairer une chambre lumineuse (216) de l'agencement de couches (200) ;
- une couche bloquant la lumière (204), recouvrant la chambre lumineuse (216), avec un évidement (214) ; et une couche de capteurs (201) recouvrant l'évidement (214) de la couche bloquant la lumière (204) ; dans lequel la couche de capteurs (201) chevauche la couche bloquant la lumière (204) en un bord de l'évidement (214) de sorte à former au bord de l'évidement (214) une zone de chevauchement (202) dans laquelle la couche bloquant la lumière (204) et la couche de capteurs se chevauchent ; dans lequel la couche de capteurs (201) bloque la lumière au moins dans la zone de chevauchement (202) ; dans lequel la couche de capteurs (201) présente une ou plusieurs zone(s) partielle(s) bloquant la lumière et une ou plusieurs zone(s) partielle(s) translucide(s) (215) qui forment ensemble un masque pour un symbole (203) à éclairer par l'élément lumineux (217) ; dans lequel la couche de capteurs (201) bloque la lumière dans la zone de chevauchement (202) ; dans lequel la couche de capteurs (201) et la couche bloquant la lumière (204) se touchent dans la zone de chevauchement (202) et sont directement reliées l'une à l'autre dans la zone de chevauchement (202), dans lequel la zone de chevauchement (202) présente une largeur de chevauchement telle que substantiellement aucune lumière provenant de la chambre lumineuse (216) n'est visible à travers la zone de chevauchement (202), dans lequel
- la couche de capteurs (201) et la couche bloquant la lumière (204) se superposent directement dans la zone de chevauchement (202) ; et
- la couche de capteurs (201) et la couche bloquant la lumière (204) sont collées l'une à l'autre dans la zone de chevauchement (202).

2. Agencement de couches (200) selon la revendication 1, dans lequel la couche de capteurs (201) est disposée sur un côté de la couche bloquant la lumière (204) éloigné de l'élément lumineux (217).

3. Agencement de couches (200) selon l'une des revendications précédentes, dans lequel la couche de capteurs (201) est disposée sur un côté de la couche bloquant la lumière (204) dirigé vers l'élément lumineux (217).

4. Agencement de couches (200) selon l'une des revendications précédentes, dans lequel
- la zone de chevauchement (202) est formée de sorte que la zone de chevauchement (202) forme un cadre fermé et/ou périphérique complet autour de l'évidement (214) de la couche bloquant la lumière (204) ; et/ou
- la zone de chevauchement (202) présente une largeur de chevauchement telle que substantiellement aucune lumière provenant de la chambre lumineuse (216) n'est visible à travers la zone de chevauchement (202).

5. Agencement de couches (200) selon l'une des revendications précédentes, dans lequel l'agencement de couches (200) comprend un séparateur et/ou un réflecteur (213) qui délimite, quant au blocage de la lumière, la chambre lumineuse (216) dans une direction parallèle à la couche bloquante (204).

6. Agencement de couches (200) selon l'une des revendications précédentes, dans lequel l'agencement de couches (200) comprend une couche diffuseur optique (212) disposée entre l'élément lumineux (217) et la couche bloquant la lumière (204), en particulier l'évidement (214) de la couche bloquant la lumière (204).

7. Agencement de couches (200) selon l'une des revendications précédentes, dans lequel l'agencement de couches (200) comprend une couche de support translucide (211) disposée sur un côté de la couche bloquant la lumière (204) éloigné de l'élément lumineux (217).

8. Agencement de couches (200) selon l'une des revendications précédentes, dans lequel la couche bloquant la lumière (204) comprend, en particulier est, une couche en plastique opaque, en particulier en polyéthylène téréphtalate, en abrégé PET.

9. Agencement de couches (200) selon l'une des revendications précédentes, dans lequel la couche de capteurs (201) est électriquement conductrice.

10. Agencement de couches (200) selon l'une des revendications précédentes, dans lequel l'évidement (214) de la couche bloquant la lumière (204) est disposé de sorte que l'évidement (214) de la couche bloquant la lumière (204) est intégralement éclairé par l'élément lumineux (217).

11. Agencement de couches (200) selon l'une des revendications précédentes, dans lequel
- l'agencement de couches (200) comprend une pluralité de chambres lumineuses (216) pour une pluralité correspondante d'éléments de commande (110) ; et
- la couche bloquant la lumière (204) comprend une pluralité d'évidements (214) pour la pluralité correspondante de chambres lumineuses (216).

12. Élément de commande (110), qui comprend
- un capteur de proximité, de contact et/ou d'actionnement (112) pour la détection d'une proximité, d'un contact et/ou d'un actionnement de l'élément de commande (110) par un utilisateur ;
- un affichage éclairé (111) ; et
- un agencement de couches (200) selon l'une des revendications précédentes ; dans lequel le capteur de proximité, de contact et/ou d'actionnement (112) et l'affichage éclairé (111) sont au moins partiellement ou intégralement formés par l'agencement de couches (200).

13. Appareil ménager (100) qui comprend au moins un élément de commande (110) selon la revendication 12.
